# EUROPEAN PATENT APPLICATION

(11) **EP 2 405 722 A1**
(43) Date of publication of application: **11.01.2012**
(21) Application number: 11173312.7
(22) Date of filing: 08.07.2011
(51) Int. Cl.: H05K 1/02, H05K 3/42, H05K 3/00, H05K 3/34

(54) **Signal transmission circuit and multilayer board**

(30) Priority: 08.07.2010 JP 2010156116
(71) Applicant: Kabushiki Kaisha Toshiba, Tokyo 105-8001 (JP)
(72) Inventor: Kajio, Hiroshi, Minato-ku, Tokyo 105-8001 (JP); Aoki, Yoshirou, Minato-ku, Tokyo 105-8001 (JP); Fukao, Kazuhito, Minato-ku, Tokyo 105-8001 (JP)
(74) Representative: Granleese, Rhian Jane

(57) **Abstract**

According to one embodiment, a signal transmission circuit includes a semiconductor (30), a multilayer board (20), and a heat radiating plate ground (10). The semiconductor (30) includes a first connection terminal and a second connection terminal. The multilayer board (20) through which a hole to mount the semiconductor (30) is formed includes a transmission path (24), an inner layer ground (23), an outer layer ground (21) and a plate portion (26). The plate portion (26) is formed by plating a part of an inner wall of the hole and extends from the inner layer ground (23) to the outer layer ground (21). The heat radiating plate (10) ground is attached to the outer layer ground (21) and connected to the second connection terminal.

## Description

### FIELD

Embodiments described herein relate generally to a signal transmission circuit and a multilayer board.

### BACKGROUND

To mount a semiconductor on a multilayer board, a hole to mount the semiconductor is formed in the multilayer board. Then, the semiconductor is mounted in the hole formed in the multilayer board. If the semiconductor is used to amplify a high-power and high-frequency signal, the semiconductor is directly mounted on a heat sink to radiate heat.

To realize a signal transmission circuit mounted with a semiconductor suited to amplify a high-power and high-frequency signal, impedance of a microstrip line, coplanar line, etc. need be designed, if necessary, with reference to an inner layer ground (GND) formed in an inner conductive layer of the multilayer board. In this case, it is ideal that an outer layer GND formed in a conductive layer of a surface of the multilayer board, the inner layer GND, and a GND in a heat sink have the same potential, so that a return current can be transmitted smoothly to the respective paths in the multilayer board, the heat sink and the semiconductor.

Conventionally, the outer layer GND and the inner layer GND are connected through a plurality of blind via holes (BVHs), in order to make the GND potentials of the outer layer GND and the inner layer GND close to each other. However, if a high-power and high-frequency input signal is supplied to a semiconductor, the BVHs in themselves have impedances and the GND potentials of the outer layer GND and the inner layer GND cannot close to each other. Therefore, the conventional signal transmission circuit of this type has a problem that the circuit characteristics are lower as compared to those of a signal transmission circuit using a double sided board.

### BRIEF DESCRIPTION OF THE DRAWINGS

FIG. 1 is a diagram showing an example of a cross section of a signal transmission circuit according to an embodiment.
FIG. 2 is a diagram showing an example of a cross section of a multilayer board taken along a broken line shown in FIG. 1.
FIG. 3 is a diagram showing a model for use in a numerical analysis about the signal transmission circuit shown in FIG. 1.
FIG. 4 is a Smith chart showing results of simulation using the model shown in FIG. 3.
FIG. 5 is a diagram showing a model for use in a numerical analysis about a signal transmission circuit of a double-sided board.
FIG. 6 is a Smith chart showing results of simulation using the model shown in FIG. 5.
FIG. 7 is a diagram showing a model for use in a numerical analysis about a signal transmission circuit which does not have a plate portion shown in FIG. 1.
FIG. 8 is a Smith chart showing results of simulation using the model shown in FIG. 7.
FIG. 9 is a diagram showing another example of a cross section of the signal transmission circuit shown in FIG. 1.
FIG. 10 is a diagram showing another example of the cross section shown in FIG. 2.

### DETAILED DESCRIPTION

In general, according to one embodiment, a signal transmission circuit includes a semiconductor, a multilayer board, and a heat radiating plate ground. The semiconductor includes a first connection terminal to input and output a signal, and a second connection terminal configured to be grounded. The multilayer board through which a hole to mount the semiconductor is formed includes a transmission path, an inner layer ground, an outer layer ground and a plate portion. The transmission path is connected to the first connection terminal. The inner layer ground is formed on a conductive layer located in an inner part of the multilayer board. The outer layer ground is formed on a conductive layer on one surface of the multilayer board. The plate portion is formed by plating a part of an inner wall of the hole and extends from the inner layer ground to the outer layer ground. The heat radiating plate ground is attached to the outer layer ground and connected to the second connection terminal.

### [First Embodiment]

An embodiment will be described below with reference to the drawings.

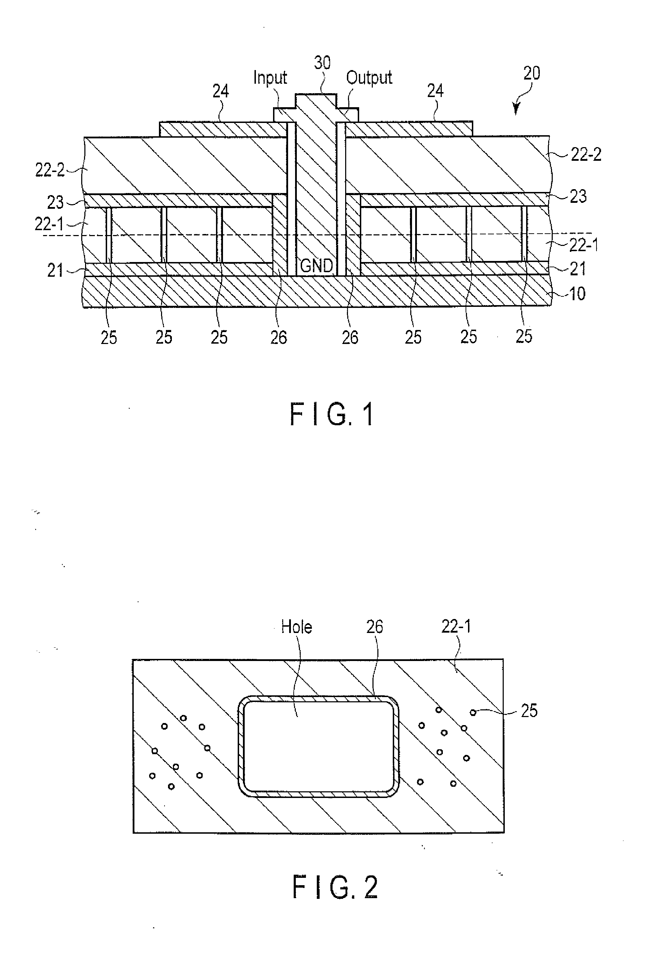

FIG. 1 is a schematic diagram showing a cross section of a signal transmission circuit of an embodiment. The signal transmission circuit in FIG. 1 comprises a heat sink 10, a multilayer board 20 and a semiconductor 30.

The heat sink 10 is attached to a bottom surface of the multilayer board 20. The heat sink 10 serves as a ground (GND) of the semiconductor 30 and radiates heat generated in the semiconductor 30. The heat sink 10 is made of a metal, which is not magnetic and has a high-frequency signal-passing performance and a high radiation performance.

The multilayer board 20 has a laminated structure, in which a plurality of conductive layers are laminated with a dielectric layer 22 inserted between every adjacent conductive layers. A hole to mount the semiconductor 30 is formed in the multilayer board 20. The hole extends through the multilayer board 20 from the top surface to the bottom surface.

An outer layer GND 21 is formed in the conductive layer located at the bottom surface of the multilayer board 20. The outer layer GND 21 is attached to the heat sink 10. An inner layer GND 23 is formed in a conductive layer located in an inner part of the multilayer board 20. The outer layer GND 21 and the inner layer GND 23 are connected through blind via holes (BVHs) 25. Of the faces of a dielectric layer 22-1 isolating the outer layer GND 21 and the inner layer GND 23, the face that faces the hole formed in the multilayer board 20 is plated. In this embodiment, the plated portion is called a plate portion 26. FIG. 2 is a schematic diagram showing a cross section of the multilayer board 20 shown in FIG. 1 taken along the broken line.

A transmission path 24 is formed in the conductive layer located at the top surface of the multilayer board 20.

The semiconductor 30 comprises a first connection terminal to input and output a signal, and a second connection terminal configured to be grounded. The first connection terminal is formed in a position in contact with a surface of the transmission path 24. The semiconductor 30 is fixed in the hole of the multilayer board 20, the first connection terminal of the semiconductor 30 is electrically connected to the transmission path 24 and the second connection terminal thereof is connected to the heat sink 10. The semiconductor 30 is grounded by the connection of the second connection terminal to the heat sink 10.

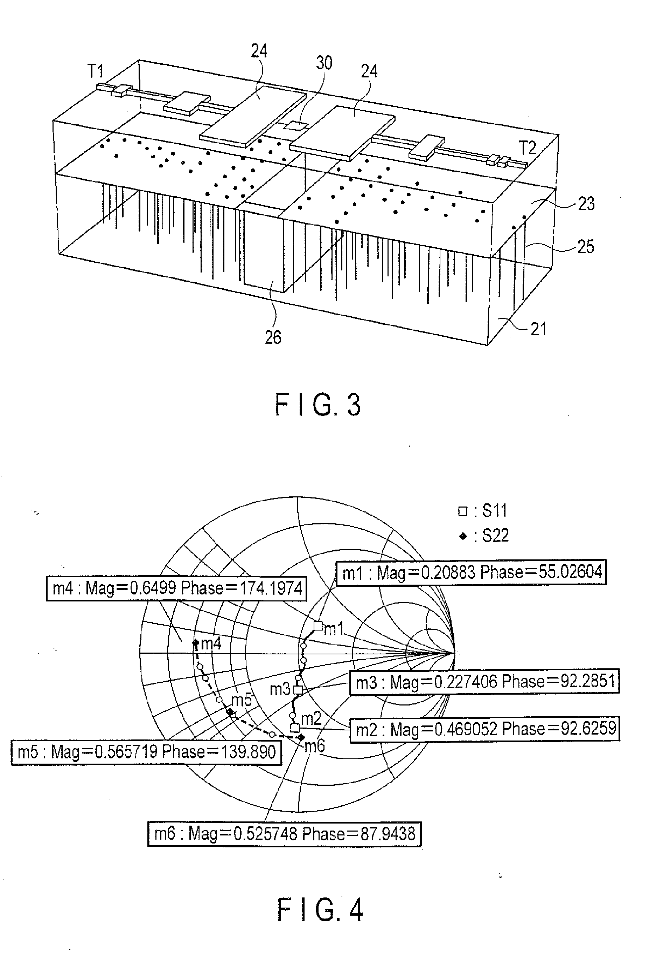

Circuit characteristics of the signal transmission circuit having the configuration described above will be described below with reference to simulation results. FIG. 3 shows a model for use in a numerical analysis about the signal transmission circuit of this embodiment. In FIG. 3, T1 denotes a first terminal and T2 denotes a second terminal. FIG. 4 is a Smith chart showing results of simulation using the model. In FIG. 4, m1 to m2 represent values of S11 of S parameters and m4 to m6 represent values of S22. S11 represents a reflection signal of a signal input to the first terminal T1 and reflected to the first terminal T1. S22 represents a reflection signal of a signal input to the second terminal T2 and reflected to the second terminal T2.

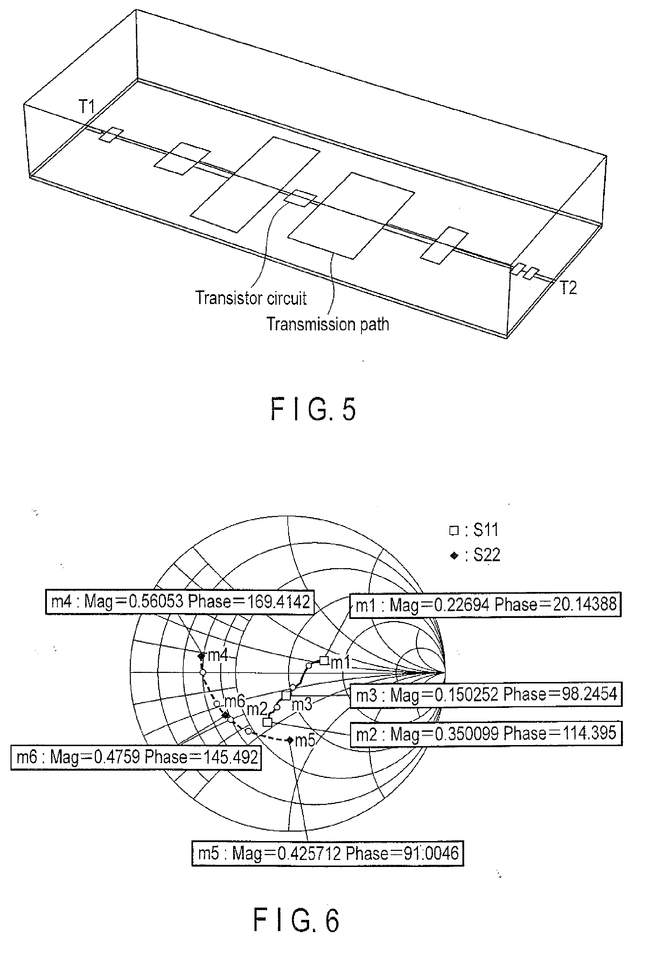

FIG. 5 shows a model for use in a numerical analysis about a signal transmission circuit of a double-sided board. FIG. 6 is a Smith chart showing results of simulation using the model shown in FIG. 5. As can be understood from FIG. 4 and FIG. 6, the values of m1 to m6 in FIG. 6 are similar to the values of m1 to m6 in FIG. 6.

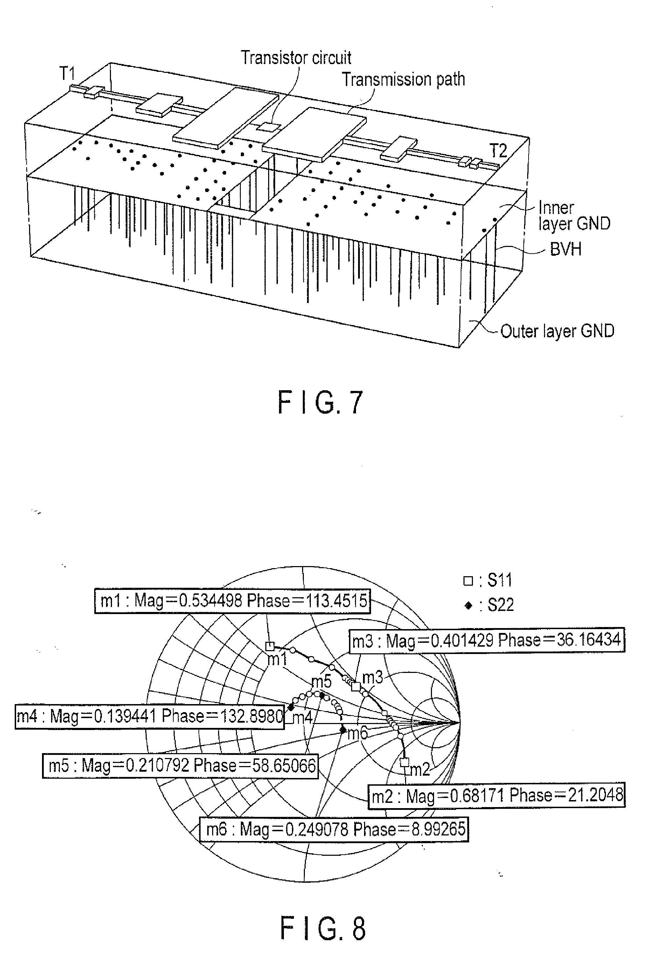

FIG. 7 is a diagram showing a model for use in a numerical analysis about a signal transmission circuit in which the plate portion 26 is not formed between the outer layer GND 21 and the inner layer GND 23; that is, the outer layer GND 21 and the inner layer GND 23 are connected by only the BVHs. FIG. 8 is a Smith chart showing results of simulation using the model shown in FIG. 7. As can be understood from FIG. 6 and FIG. 8, the values of m1 to m6 in FIG. 8 are considerably different from the values of m1 to m6 in FIG. 6.

As described above, in this embodiment, of the faces of the dielectric layer 22-1 isolating the outer layer GND 21 and the inner layer GND 23, the face that faces the hole formed in the multilayer board 20 is plated. In other words, the outer layer GND 21 and the inner layer GND 23 are connected by the plate portion 26 near the semiconductor 30, where the return current concentrates most. As a result, the connection between outer layer GND 21 and the inner layer GND 23 is reinforced, and the return current can easily flow. Accordingly, the characteristics of the circuit including the semiconductor can be maintained satisfactorily.

Generally, to make the GND potentials of the outer layer GND and the inner layer GND close to each other, BVHs may be formed between the outer layer GND and the inner layer GND as shown in FIG. 7. However, when a high-power and high-frequency signal is input, the BVHs in themselves have an impedance and the GND potentials of the outer layer GND and the inner layer GND cannot close to each other. Therefore, as shown in FIG. 8, the circuit characteristics are lower as compared to those of a circuit using a double-sided board shown in FIG. 6.

In contrast, the multilayer board shown in FIG. 3 has the circuit characteristics as shown in FIG. 4 because of the plate portion 26. Thus, even if a high-power and high-frequency signal is input, the multilayer board can have circuit characteristics close to those of the double-sided board shown in FIG. 5.

Therefore, the signal transmission circuit of this embodiment can maintain satisfactory circuit characteristics, even if the semiconductor is mounted on the multilayer board. Moreover, in the multilayer board of this embodiment, the circuit characteristics are suppressed from being degraded.

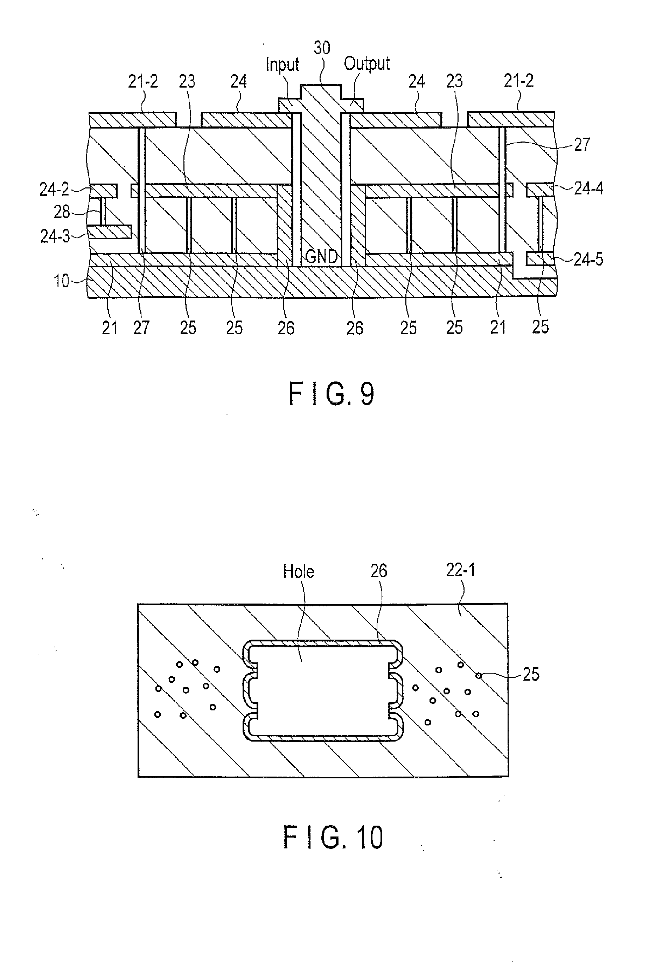

Although the signal transmission circuit of the structure shown in FIG. 1 has been described above as the embodiment, the structure of the signal transmission circuit is not limited thereto. For example, the signal transmission circuit may have a structure shown in FIG. 9. Specifically, the signal transmission circuit may have, on the top surface, an outer layer GND 21-2, which is connected to the outer layer GND 21 on the bottom surface via through holes 27. Further, transmission paths 24-2 to 24-4 may be formed on a conductive layer in an inner part of the multilayer board. The transmission paths 24-2 to 24-3 in the inner part of the multilayer board may be connected through an interstitial via hole (IVH) 28. Furthermore, the plate portion 26 of this embodiment may additionally be processed by a special process, such as a resin filling process.

In the embodiment described above, the plate portion 26 is formed, for example, entirely on the inner surface of the hole as shown in FIG. 2. However, the plate portion 26 is not limited to this example. Even if the plate portion 26 is not formed in a part of the inner surface of the hole as shown in FIG. 10, the embodiment can be carried out in the same manner.

Further, in the embodiment described above, the multilayer board 20 comprises, for example, one inner layer GND. However, the embodiment is not limited to this example. The multilayer board 20 may have a plurality of inner layer GNDs, which are all connected to the outer layer GND 21 via plate portions.

In the embodiment described above, the outer layer GND 21 and the inner layer GND 23 are connected through the BVHs 25, for example. However, the embodiment is not limited to this example. The BVHs 25 may not necessarily be formed.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A signal transmission circuit **characterized by** comprising:
a semiconductor (30) comprising a first connection terminal to input and output a signal, and a second connection terminal configured to be grounded;
a multilayer board (20) through which a hole to mount the semiconductor (30) is formed and which comprises a transmission path (24), an inner layer ground (23), an outer layer ground (21) and a plate portion (26), the transmission path (24) being connected to the first connection terminal, the inner layer ground (23) being formed on a conductive layer located in an inner part of the multilayer board (20), the outer layer ground (21) being formed on a conductive layer on one surface of the multilayer board (20), the plate portion (26) being formed by plating a part of an inner wall of the hole and extending from the inner layer ground (23) to the outer layer ground (21); and
a heat radiating,plate ground (10) which is attached to the outer layer ground (21) and connected to the second connection terminal.

2. The signal transmission circuit according to claim 1, **characterized in that** the inner layer ground (23) and the outer layer ground (21) are further connected by a plurality of blind via holes (BVHs) (25).

3. The signal transmission circuit according to claim 1, **characterized in that** the semiconductor (30) amplifies a high-power and high-frequency signal.

4. A multilayer board (20) through which a hole to mount a semiconductor (30) is formed and which comprises conductive layers in an inner part and surfaces, the multilayer board (20) **characterized by** comprising:
a transmission path (24) connected to a connection terminal of the semiconductor (30);
an inner layer ground (23) formed on the conductive layer in the inner part;
an outer layer ground (21) formed on the conductive layer on one of the surfaces; and
a plate portion (26) formed by plating a part of an inner wall of the hole, the plate portion (26) extending from the inner layer ground (23) to the outer layer ground (21).

5. The multilayer board according to claim 4, **characterized in that** the inner layer ground (23) and the outer layer ground (21) are further connected by a plurality of blind via holes (BVHs) (25).

6. The multilayer board according to claim 4, **characterized in that** the semiconductor (30) amplifies a high-power and high-frequency signal.
